# EUROPEAN PATENT APPLICATION

(11) **EP 2 840 663 A1**
(43) Date of publication of application: **25.02.2015**
(21) Application number: 14002808.5
(22) Date of filing: 12.08.2014
(51) Int. Cl.: H01R 13/53, G01R 31/12

(54) **Connector apparatus for measuring cable degradation**

(30) Priority: 23.08.2013 KR 20130100509; 04.11.2013 KR 20130133064
(71) Applicant: Korea Electric Power Corporation, Seoul 135-791 (KR)
(72) Inventor: Joung, Hanju, Gwangju 500-751 (KR); Kang, Cheulwon, Seoul 143-200 (KR); Park, Sangwan, Gwangju 506-307 (KR); Cho, Yunseog, Gwangju 500-890 (KR)
(74) Representative: Flaccus, Rolf-Dieter

(57) **Abstract**

Disclosed herein is a connector apparatus for measuring cable degradation. The connector apparatus for measuring cable degradation includes a body formed of a dielectric material, a connection fitting installed to pass through the body, a bushing insert which is formed at one side of the body, into which one side of the connection fitting is inserted, and which is inserted into a connector of a power facility, a connecting socket which is formed at the other side of the body, which encloses the other side of the connection fitting, and which is spaced apart from the connection fitting to form a connecting space such that a connecting plug of diagnostic equipment is inserted therein, and at least one skirt is formed to protrude from an outer surface of the body.

## Description

### BACKGROUND OF THE INVENTION

### 1. Technical Field

The present invention relates generally to a connector apparatus for measuring cable degradation and, more particularly, to a connector apparatus for measuring cable degradation, capable of reducing a measurement error when the cable degradation is measured.

### 2. Description of the Related Art

Power cables are generally stressed by heat, electricity, and environmental or mechanical factors. When power cables are under tension for extended periods of time, the power cables are subjected to a change in physical property, which is called degradation. With the gradation of power cables, the power cables may suffer dielectric breakdown.

To measure the degradation of the power cables, a very low frequency (VLF) diagnosis method is applied. In detail, elbow connectors are connected on both sides of each cable installed between power facilities. A dielectric cap and a connecting plug are separated from one of the elbow connectors, and a bushing insert is inserted into the separated elbow connector. A test rod is coupled to the bushing insert, and a clamp connected to diagnostic equipment is coupled to the test rod. The diagnostic equipment is connected to the bushing insert and a power cable by the clamp, and diagnoses a degraded state of the power cable.

The related art of the present invention is disclosed in Korean Unexamined Patent Application Publication No. 10-2012-0024043 (published on March 14, 2012, and entitled DEVICE AND METHOD OF DEGRADATION DIAGNOSIS FOR POWER CABLE).

### SUMMARY OF THE INVENTION

Conventionally, since the bushing insert, the test rod, and the clamp are sequentially coupled, a time required to diagnose the degradation of the cable may be increased. Further, both a region in which the bushing insert and the test rod are connected and a region in which the test rod and the clamp are connected are exposed to an external environment. As the exposed regions come into contact with foreign material or moisture, such contact has an influence on the VLF diagnosis, and thus it is difficult to accurately measure the degraded state of the cable. Further, when the bushing insert is inserted into the test rod and when the clamp is coupled to the test rod, fine voids or defects may occur at the connected regions. As such, such voids or defects make it difficult to accurately measure the degraded state of the cable. When the degraded state of the cable is inaccurately measured, either a good cable is unnecessarily replaced, or the degradation must be re-assessed, so that replacement or diagnosis expenses can be increased. Therefore, there is a need to improve this situation.

Accordingly, the present invention has been made keeping in mind the above problems occurring in the prior art, and an object of the present invention is to provide a connector apparatus for measuring cable degradation, capable of reducing a time to diagnose the cable degradation.

Another object of the present invention is to provide a connector apparatus for measuring cable degradation, capable of preventing external contamination by foreign materials or moisture.

In order to accomplish the above object, the present invention provides a connector apparatus for measuring cable degradation, which includes: a body formed of a dielectric material; a connection fitting installed to pass through the body; a bushing insert which is formed at one side of the body, into which one side of the connection fitting is inserted, and which is inserted into a connector of a power facility; a connecting socket which is formed at the other side of the body, which encloses the other side of the connection fitting, and which is spaced apart from the connection fitting to form a connecting space such that a connecting plug of diagnostic equipment is inserted; and at least one skirt formed to protrude from an outer surface of the body.

Here, the connector apparatus as set forth in claim 1, further comprising a conductor shielding part that is formed to surround the one side of the body and to have a greater diameter than the bushing insert.

Further, the connecting socket may have pressing ridges formed on an inner surface thereof such that an outer surface of the connecting plug is pressed.

Further, the skirts may be formed at all sides of the body.

Also, the skirts may be formed in an annular disk shape, and outer ends thereof may have the same height from the outer surface of the body.

Further, the outer ends of the skirts may be formed to be round.

Further, the bushing insert may be formed in a cylindrical shape in which an outer diameter thereof is reduced from the one side of the body to an end thereof.

Meanwhile, the conductor shielding part may be formed to have an outer diameter that is smaller than that of the skirt and is greater than that of the bushing insert.

Further, the body may be formed in a cylindrical shape.

Further, the connecting socket may be formed in a cylindrical shape.

In addition, the body may be formed of ethylene propylene diene monomer (EPDM) rubber.

According to the present invention, since the connector apparatus for measuring cable degradation is integrally formed, it is possible to reduce a time to diagnose the cable degradation.

Further, since the connection fitting is surrounded with a dielectric material, it is possible to prevent foreign materials and moisture from being attached from the outside.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a perspective view illustrating connectors of cables, each of which is connected by a connector apparatus for measuring cable degradation according to an embodiment of the present invention;
FIG. 2 is a configuration view illustrating a diagnosis apparatus and the connector apparatus for measuring cable degradation according to the embodiment of the present invention;
FIG. 3 is a perspective view illustrating the connector apparatus for measuring cable degradation according to the embodiment of the present invention; and
FIG. 4 is a front view illustrating the connector apparatus for measuring cable degradation according to the embodiment of the present invention.

### DESCRIPTION OF THE PREFERRED EMBODIMENTS

The present invention will be described in detail below with reference to the accompanying drawings. Repeated descriptions and descriptions of known functions and configurations which have been deemed to make the gist of the present invention unnecessarily obscure will be omitted below. The embodiment of the present invention is intended to fully describe the present invention to a person having ordinary knowledge in the art to which the present invention pertains. Accordingly, the shapes, sizes, etc. of components in the drawings may be exaggerated to make the description clearer.

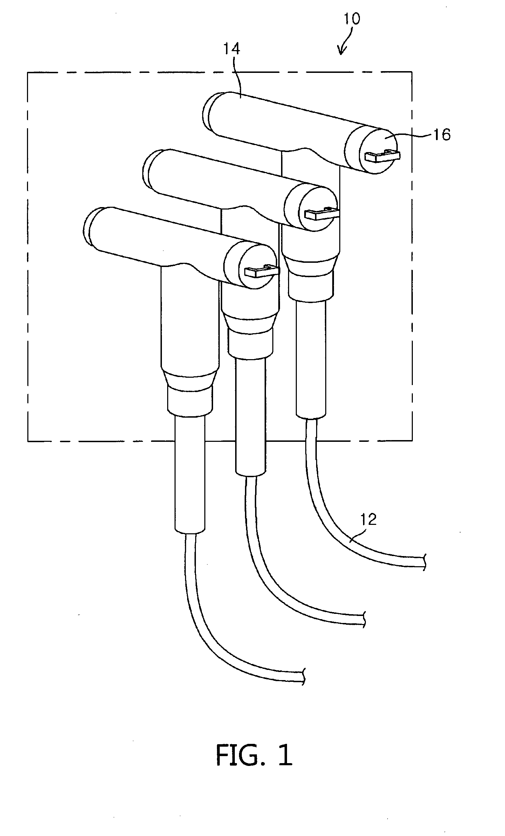

FIG. 1 is a perspective view illustrating connectors of cables, each of which is connected by a connector apparatus for measuring cable degradation according to an embodiment of the present invention.

Referring to FIG. 1, a power facility 10 is connected by cables 12. The power facility 10 is equipped with connectors 14 to which the cables 12 are connected. The connectors 14 are formed in an elbow shape. Each connector 14 is equipped with a connecting plug 23, and a dielectric cap 16 for isolating the connecting plug 23 and an interior of the connector 24 from the outside. After the dielectric gap 16 and the connecting plug 23 are separated from the connector 14, a connector apparatus 100 for measuring cable degradation is coupled to the connector 14.

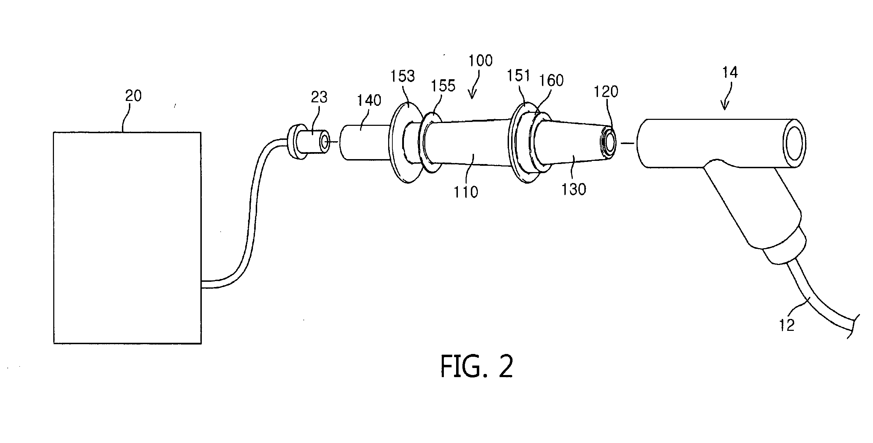

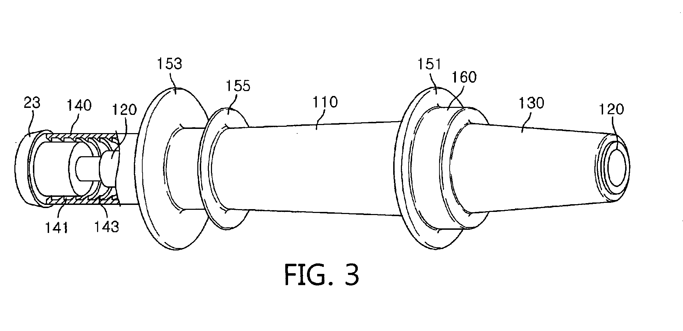

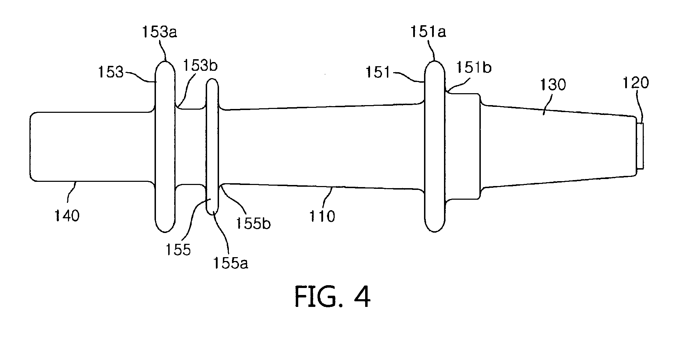

FIG. 2 is a configuration view illustrating a diagnosis apparatus and the connector apparatus for measuring cable degradation according to the embodiment of the present invention. FIG. 3 is a perspective view illustrating the connector apparatus for measuring cable degradation according to the embodiment of the present invention. FIG. 4 is a front view illustrating the connector apparatus for measuring cable degradation according to the embodiment of the present invention.

Referring to FIGS. 2 to 4, the connector apparatus 100 for measuring cable degradation includes a body 110, a connection fitting 120, a bushing insert 130, a connecting socket 140, and skirts 151, 153, and 155.

The body 110 is formed of a dielectric material. In this case, the body 110 may be formed in a cylindrical shape. If the body 110 is formed in the cylindrical shape, this allows leakage current of the cable 12 to uniformly flow across the surface of the body 110. Thus, it is possible to prevent the leakage current from being concentrated on a specific region of the body 110 and to prevent the specific region of the body 110 from suffering dielectric damage.

The body 110 may be formed of a material, such as ethylene propylene diene monomer (EPDM) rubber, that is excellent in dielectric property, corrosion resistance, heat resistance, and mechanical strength. EPDM rubber is a dielectric material capable of maintaining 2000 MΩ or more at DC 1000 V, and withstanding 55 kV of power for about 1 minute.

The connection fitting 120 is installed to pass through the body 110. Since the connection fitting 120 is installed to pass through the body 110, the connection fitting 120 can be isolated from the outside. Since the connection fitting 120 is isolated from foreign materials, humidity, moisture, and external shocks, a change in resistance and capacitance components at the connection fitting can be prevented. Thus, during very low frequency (VLF) diagnosis, a change in phase difference between test voltage and current can be prevented.

The connection fitting 120 is formed in a circular rod shape on the whole. The connection fitting 120 is formed to have a relatively small diameter such that the connecting plug 23 of diagnostic equipment 20 is coupled to an end thereof.

The bushing insert 130 is formed at one side of the body 110. One side of the connection fitting 120 is inserted into the bushing insert 130. Here, one end of the connection fitting 120 is exposed to outside of the bushing insert 130, and is electrically connected to an electric wire (not shown) disposed inside the connector 14 of the power facility 10.

Since one side of the connection fitting 120 is inserted into the bushing insert 130, one side of the connection fitting 120 is blocked from foreign materials, humidity, moisture, and external shocks. Thus, a change in resistance and capacitance components at the connection fitting can be prevented. As such, during VLF diagnosis, a change in phase difference between test voltage and current can be prevented.

The bushing insert 130 is formed in a cylindrical shape in which an outer diameter thereof is reduced from one side to one end of the body 110. Thus, the bushing insert 130 can be easily press-fitted into the connector 14 of the power facility 10. Further, as the bushing insert 130 is deeply inserted into the connector 14 of the power facility 10, a force for press-fitting the bushing insert 130 into the connector 14 is gradually increased, so that the busing insert 130 can be prevented from being separated from the connector 14. In addition, since the busing insert 130 is formed in the cylindrical shape, the bushing insert 130 may be press-fitted into the connector 14 of the power facility 10 while being turned.

The bushing insert 130 may be formed of a material, such as EPDM rubber, that is excellent in dielectric property, corrosion resistance, heat resistance, and mechanical strength.

The connecting socket 140 is formed at the other side of the body 110. The connecting socket 140 is installed to surround the other side of the connection fitting 120. The connecting socket 140 is spaced apart from the connection fitting 120, thereby forming a connecting space 141 such that the connecting plug 23 of the diagnostic equipment 20 is inserted thereinto.

Since the connecting socket 140 is installed to surround the other side of the connection fitting 120 while forming the connecting space 141, the other side of the connection fitting 120 can be protected from the external environment. Since the other side of the connection fitting 120 is isolated from the outside by the connecting socket 140, the other side of the connection fitting 120 is blocked from foreign materials, humidity, moisture, and external shocks. Thus, a change in resistance and capacitance components at the connecting socket 140 can be prevented. As such, during VLF diagnosis, a change in phase difference between test voltage and current can be prevented.

The connecting socket 140 is formed in a cylindrical shape. Since the connecting socket 140 is smoothly formed in the cylindrical shape, it is possible to prevent the leakage current of the cable 12 from being concentrated on a specific region of the connecting socket 140 and to prevent the specific region of the connecting socket 140 from suffering dielectric damage.

The connecting socket 140 is provided with pressing ridges 143 on an inner surface thereof against which an outer surface of the connecting plug 23 of the diagnostic equipment 20 is pressed. Since the pressing ridges 143 press the connecting plug 23, it is possible to prevent the connecting plug 23 of the diagnostic equipment 20 from being separated from the connecting socket 140. The pressing ridges 143 may be formed in various shapes.

The connecting socket 140 may be formed of a material, such as EPDM rubber, that is excellent in dielectric property, corrosion resistance, heat resistance, and mechanical strength.

The skirts 151, 153, and 155 are formed to protrude from an outer surface of the body 110. The skirts 151, 153, and 155 prolong a path (dielectric length) along which leakage current flows. As such, the leakage current of the cable 12 is dissipated while it flows along surfaces of the skirts 151, 153, and 155. Thus, the skirts 151, 153, and 155 perform a blocking function of the leakage current.

The skirts 151, 153, and 155 are formed at the opposite sides of the body 110. Since the skirts 151 and 153 are formed at the opposite sides of the body 110, the leakage current can further prolong the path along which the leakage current flows. Thus, the blocking function of the leakage current can be improved. A structure in which the three skirts 151, 153, and 155 are formed is illustrated in FIG. 3. However, the number of skirts 151, 153, and 155 can be variously changed.

The skirts 151 and 153 are formed in an annular disk shape. Since the skirts 151 and 153 are formed in the annular disk shape, outer ends of the skirts 151 and 153 are formed on the outer surface of the body 110 at the same height. Thus, the path along which the leakage current flows can be uniformly increased in a radial direction of the body 110.

The outer ends of the skirts 151, 153, and 155 are formed to be round. Since the outer ends 151a, 153a, and 155a of the skirts 151, 153, and 155 are rounded, it is possible to prevent the outer ends 151a, 153a, and 155a of the skirts 151, 153, and 155 from being edged. Thus, it is possible to prevent the leakage current from being concentrated on the outer ends 151a, 153a, and 155a of the skirts 151, 153, and 155 and to prevent the outer ends 151a, 153a, and 155a of the skirts 151, 153, and 155 from suffering dielectric damage.

Joint regions 151b, 153b, and 155b between the skirts 151, 153, and 155 and the body 110 are formed to be round. Thus, it is possible to prevent the joint regions 151b, 153b, and 155b between the skirts 151, 153, and 155 and the body 110 from being angled, and to prevent the leakage current from being concentrated on the regions 151b, 153b, and 155b between the skirts 151, 153, and 155 and the body 110.

A conductor shielding part 160 formed to surround one side of the body 110 is further provided. The conductor shielding part 160 is formed to have a diameter greater than a diameter of the bushing insert 130. Here, a portion at which the conductor shielding part 160 and the bushing insert 130 are joined is formed to be round. Further, a portion at which conductor shielding part 160 and the skirt 151 is also formed to be round. Thus, it is possible to prevent the leakage current from being concentrated on the joined portions of the conductor shielding part 160.

The conductor shielding part 160 fills up a gap between the connector 14 of the power facility 10 and the bushing insert 130. The conductor shielding part 160 relieves an electric field before the leakage current of the cable 12 flows to the body 110 of the connector apparatus 100 for measuring cable degradation, and thus makes a curve of potential gradient smooth. The conductor shielding part 160 causes the leakage current to be uniformly distributed on the whole. As such, a shock of the electric field transmitted to the body 110 is relieved and buffered, thereby preventing damage to the body 110. The conductor shielding part 160 may be formed of an ethylene propylene polymer containing conductive carbons.

An operation of the connector apparatus for measuring cable degradation, which is configured as described above, according to the present invention will be described.

Each cable 12 is insulated with a polymer dielectric sheath. When the dielectric sheath is stressed for a long time by heat, electricity, and environmental and mechanical factors, its original physical properties change in an undesirable manner, which is called degradation. The cable 12 is reduced in service life by degradation.

A speed at which the cable 12 is degraded varies depending on a shape, conditions, an available environment, etc. of the cable 12 itself. Primary factors causing degradation include: a water tree, a chemical tree, and an electrical tree. The water tree refers to a tree in which, when water is present in the cable 12, a high electric field is locally concentrated on a water-filled region, and the degradation proceeds along a branch-like path. The chemical tree refers to a tree in which, as an external sulfide penetrates a dielectric material, the sulfide reacts with a copper component to form copper sulfide, and the degradation proceeds along a branch-like path while copper sulfide escapes. The electrical tree refers to a tree in which, as partial discharges occur at defects such as voids or projections in the cable 12, the degradation proceeds along a branch-like path. As the tree proceeds in the cable 12, dielectric breakdown takes place.

If the cable 12 is degraded to some extent, it is replaced with a new cable 12. To measure a degree of degradation of the cable 12, the connector apparatus 100 for measuring cable degradation is used. Hereinafter, a process of measuring the degradation of the cable 12 will be described.

The dielectric cap 16 and the connecting plug 23 are separated from the connector 14 of the power facility 10. The body 110 is grasped by the hand, and then the bushing insert 130 is pressed into the connector 14. Here, since the bushing insert 130 is formed in such a manner that the outer diameter thereof is reduced toward the end thereof, the bushing insert 130 can be easily pressed. Further, as the bushing insert 130 is pressed into the connector 14, a pressing force is increased. As such, the bushing insert 130 can be prevented from coming out of the connector 14.

The connecting plug 23 of the diagnostic equipment 20 is coupled to the connecting socket 140. Here, the connecting plug 23 is electrically connected to the connection fitting 120.

In this way, since the connection fitting 120, the bushing insert 130, and the connecting socket 140 are integrally formed, the connector apparatus 100 for measuring cable degradation can be easily connected to the connector 14 of the power facility 10. Thus, it is possible to reduce a degradation measurement time of the cable 12. Further, the connector apparatus 100 for measuring cable degradation can be easily and rapidly separated from the connector 14 of the power facility 10.

A test voltage is applied to the connection fitting 120 from the diagnostic equipment 20. As the test voltage is applied, the cable 12 is charged with the voltage. As the cable 12 is charged with the voltage, an electric current is generated from a wire that is a conductor. The electric current flows from a surface of the wire to a dielectric sheath. Here, the cable 12 acts as a capacitor that repeats charge and discharge of the electric current.

In an ideal state in which the cable is not degraded, a phase difference between the test voltage and the electric current is 90 degrees. If the cable 12 is degraded, the resistance and capacitance components vary at the cable 12. Thus, the degradation degree of the cable 12 can be diagnosed by measuring the phase difference between the test voltage and the electric current.

Meanwhile, since the connection fitting 120 is shielded from the external environment by the body 110, the bushing insert 130, and the connecting socket 140, it is possible to prevent foreign materials and moisture from being attached to the connection fitting 120. Further, the connection fitting 120 can be prevented from being scratched. Here, since a change in the test voltage can be prevented by the connection fitting 120, it is possible to prevent the phase difference between the test voltage and the electric current from being influenced at the cable 12 by the external environment. Thus, the degradation degree of the cable 12 can be accurately measured, so that a time to replace the cable 12 can be accurately diagnosed. Further, it is unnecessary to diagnose the degradation of the cable 12 again, and it is possible to prevent the cable 12 whose service life is left from being replaced due to an error in diagnosis.

Also, the conductor shielding part 160 relieves an electric field before the leakage current of the cable 12 flows to the body 110 of the connector apparatus 100 for measuring cable degradation. Here, the conductor shielding part 160 causes the leakage current to be uniformly distributed on the whole. As such, a shock of the electric field transmitted to the body 110 is relieved or buffered, and thus the body 110 formed of a dielectric material can be protected from dielectric damage. As a result, it is possible to prolong a service life of the connector apparatus 100 for measuring cable degradation.

In addition, since the skirts 151, 153, and 155 are formed to protrude from the body 110, a dielectric length of the connector apparatus 100 for measuring cable degradation is increased. Thus, the body 110 is protected from the dielectric damage, and the leakage current is adapted to be dissipated at the body 110, so that the connection fitting 120 can be prevented from being influenced by the leakage current. Accordingly, the phase difference between the test voltage and the electric current can be prevented from being influenced by the connector apparatus 100 for measuring cable degradation.

As described above, the optimal embodiment of the present invention has been disclosed in the drawings and the specification. Although specific terms have been used in the present specification, these are merely intended to describe the present invention and are not intended to limit the meanings thereof or the scope of the present invention described in the accompanying claims. Therefore, those skilled in the art will appreciate that various modifications and other equivalent embodiments are possible from the embodiment. Therefore, the technical scope of the present invention should be defined by the technical spirit of the claims.

## Claims

1. A connector apparatus (100) for measuring cable degradation comprising:
a body (110) formed of a dielectric material;
a connection fitting (120) installed to pass through the body (110);
a bushing insert (130) which is formed at one side of the body (110), into which one side of the connection fitting (120) is inserted, and which is inserted into a connector (14) of a power facility (10);
a connecting socket (140) which is formed at the other side of the body (110), which encloses the other side of the connection fitting (120), and which is spaced apart from the connection fitting (120) to form a connecting space (141) such that a connecting plug (23) of diagnostic equipment (20) is inserted; and
at least one skirt (151, 153, 155) formed to protrude from an outer surface of the body (110).

2. The connector apparatus (100) as set forth in claim 1, further comprising a conductor shielding part (160) that is formed to surround the one side of the body (110) and to have a greater diameter than the bushing insert (130).

3. The connector apparatus (100) as set forth in claim 2, wherein the connecting socket (140) has pressing ridges (143) formed on an inner surface thereof such that an outer surface of the connecting plug (23) is pressed.

4. The connector apparatus (100) as set forth in claim 1, wherein the skirts (151, 153, 155) are formed at the one and other sides of the body (110).

5. The connector apparatus (100) as set forth in claim 4, wherein the skirts (151, 153) are formed in an annular disk shape, and outer ends thereof have the same height from the outer surface of the body (110).

6. The connector apparatus (100) as set forth in claim 4, wherein the outer ends of the skirts (151, 153, 155) are formed to be round.

7. The connector apparatus (100) as set forth in claim 2, wherein the bushing insert (130) is formed in a cylindrical shape in which an outer diameter thereof is reduced from the one side of the body (110) to an end thereof.

8. The connector apparatus (100) as set forth in claim 7, wherein the conductor shielding part (160) is formed to have an outer diameter that is smaller than that of the skirt (151, 153, 155) and is greater than that of the bushing insert (130).

9. The connector apparatus (100) as set forth in claim 1, wherein the body (110) is formed in a cylindrical shape.

10. The connector apparatus (100) as set forth in claim 9, wherein the connecting socket (140) is formed in a cylindrical shape.

11. The connector apparatus (100) as set forth in claim 1, wherein the body (110) is formed of ethylene propylene diene monomer (EPDM) rubber.
